# EUROPÄISCHE PATENTSCHRIFT

(11) **EP 1 580 295 B1**
(45) Veröffentlichungstag und Bekanntmachung des Hinweises auf die Patenterteilung: **04.06.2008**
(21) Anmeldenummer: 04017807.1
(22) Anmeldetag: 28.07.2004
(51) Int. Cl.: C23C 14/00, C23C 14/54, C23C 14/56

(54) **Einrichtung zum reaktiven Sputtern**
Apparatus for reactive sputtering
Dispositif pour la pulvérisation réactive

(30) Priorität: 26.03.2004 DE 102004014855
(43) Veröffentlichungstag der Anmeldung: 28.09.2005
(73) Patentinhaber: Applied Materials GmbH & Co. KG, 63755 Alzenau (DE)
(72) Erfinder: Fritz, Thomas, 63579 Freigericht (DE); Kemmerer, Günter, 63755 Alzenau (DE)
(74) Vertreter: Schickedanz, Willi

(56) Entgegenhaltungen:
- EP-A- 0 349 187
- WO-A-98/42890
- DE-A1- 4 311 360
- US-A- 4 201 645
- US-A- 4 870 388
- US-A- 5 169 509

## Beschreibung

Die Erfindung betrifft eine Einrichtung zum reaktiven Sputtern nach dem Oberbegriff des Patentanspruchs 1.

Beim reaktiven Sputtern werden in der Regel wenigstens zwei Gase verwendet: ein meist inertes Gas, welches in ionisierter Form Partikel aus einem Target schlägt, und ein Reaktivgas, das mit den herausgeschlagenen Partikeln eine Verbindung eingeht. Diese Verbindung schlägt sich dann als dünne Schicht auf einem Substrat nieder, beispielsweise auf einer Glasscheibe.

Damit Ionen eines Inertgases auf ein Target beschleunigt werden können, muss an dieses Target eine elektrische Spannung angelegt werden. Diese zwischen dem Target und einem Gegenpol liegende Spannung hängt unter anderem von dem Gasdruck ab, der in einer Sputterkammer herrscht. Wird ein zu beschichtendes und elektrisch nicht leitendes Substrat durch eine Sputterkammer bewegt, kann die Spannung auch noch von dem jeweiligen Ort des Substrats abhängen.

Die Abhängigkeit der Spannung von dem Druck erklärt sich dadurch, dass sich bei höherem Druck noch Atome im Gasraum befinden, sodass auch mehr Ladungsträger erzeugt werden. Hierdurch fließt bei gleicher elektrischer Leistung ein höherer Entladestrom, wobei die Spannung sinkt.

Die Abhängigkeit der Spannung vom Ort des Substrats erklärt sich wie folgt:

Bewegt sich das elektrisch nicht leitende Substrat unter der Sputterkathode mit dem Target vorbei, so deckt das Substrat immer mehr Anodenraum unterhalb des Targets ab. Hierdurch wird die Anode kleiner, weshalb bei gleicher Leistung die Anodenspannung erhöht werden muss, um den erforderlichen Strom zu ziehen.

Das Plasma wird auch noch durch einen Verschmutzungseffekt beeinflusst, der dadurch auftritt, dass sich auf dem Target Reaktivprodukte ablagern.

Gibt das Reaktivprodukt mehr Sekundärelektronen ab als das metallische Target, so wird der Anteil der elektrisch geladenen Teilchen des Plasmas erhöht. Hierdurch sinkt die Plasmaimpedanz, sodass bei konstanter elektrischer Leistung ein höherer Strom bei niedrigerer Spannung fließt. Dieser Effekt wird verstärkt, wenn der Anteil des Reaktivgases im Verhältnis zum Inertgas erhöht wird.

Werden z. B. Aluminium-Targets in einer sauerstoffhaltigen Atmosphäre gesputtert, so hat das entstehende Aluminiumoxid eine im Vergleich zum metallischen Aluminium um das Siebenfache erhöhte Sekundärelektronenemission. Auf der anderen Seite ist meist die Sputterrate des Reaktivproduktes niedriger als die des reinen Metalls.

Die vorstehend beschriebenen Effekte haben zur Folge, dass mit steigenden Reaktivgasanteilen die Entladespannung sinkt und bei gleicher Leistung ein höherer Strom bei niedrigerer Spannung fließt.

Es ist bereits eine Sputterbeschichtungsanlage bekannt, die eine Regelung aufweist, mit der die Kathodenleistung auf einen vorgegebenen Betriebswert eingestellt werden kann (DE 101 35 761 A1, EP 1 197 578 A2). Außer der Kathodenleistung wird auch noch der Gasfluss des Reaktivgases mit Hilfe einer Fuzzy-Logik geregelt.

Weiterhin ist eine Sputterbeschichtungsanlage bekannt, die eine Regelschaltung aufweist, die die Messgröße, welche die Kathodenspannung angibt, sowie die Messgröße, welche die Einbrüche der Kathodenspannung angibt, erfasst und in Abhängigkeit von diesen Messgrößen den Gasfluss des Reaktivgases basierend auf einer Fuzzy-Logik steuert (DE 101 35 802 A1).

Bei einem bekannten Verfahren zum Erhöhen der Sputterrate bei Reaktivsputterprozessen werden Halogene zu einem eigentlichen Argon-Reaktivgasgemisch gegeben (EP 0 349 187 A2). Da bei einem bestimmten Mischungsverhältnis von Argon/Reaktivgas zum Halogen ein Maximum in der Sputterrate auftritt, wird dieses Mischungsverhältnis durch Regelung konstant gehalten. Die Entladespannung wird hierbei nicht geregelt.

Aus der US 4 870 388 ist ein Verfahren für die Herstellung eines wärmeerzeugenden Widerstandselements bekannt. Auch hier wird nicht die Entladespannung geregelt, sondern die Konzentration von Halogenatomen in einer Widerstandsschicht.

Um eine gewünschte Spannung beizubehalten, ist aus WO 98/42890 eine Verhältnisgas-Steuereinheit bekannt. Das Verhältnis der Partialdrücke der einzelnen Gase bleibt hierbei jedoch nicht konstant. Es sind deshalb auch keine Drucksensoren vorgesehen.

Ferner ist ein Sputtersystem mit geschlossenem Regelkreis bekannt, das eine Regelung aufweist, um die Spannung der Target-Elektrode mittels des Gasflusses zu regeln, und zwar ohne Messung des Drucks des Sputtersystems (US 4 201 645). Von einer Mischung mehrerer Gase ist hierbei nicht die Rede.

Schließlich ist auch noch eine Beschichtungsanlage bekannt, die zwei Magnetron-Kathoden aufweist, die jeweils mit einem ungeerdeten Anschluss einer Wechselspannungsquelle verbunden sind (US 5 169 509). Die Entladespannung wenigstens einer dieser Kathoden wird gemessen, und der Fluss von Reaktivgas in die Kammer wird geregelt, sodass die gemessene Spannung identisch mit der Soll-Spannung ist. Ein Regeln eines Gesamtgasflusses oder -gasdrucks ist hierbei nicht vorgesehen.

Der Erfindung liegt die Aufgabe zugrunde, die Kathodenspannung einer reaktiven Beschichtungsanlage konstant zu halten bei gleichzeitiger Beibehaltung einer gleichmäßig hohen Beschichtungsrate.

Diese Aufgabe wird gemäß den Merkmalen des Patentanspruchs 1 gelöst.

Die Erfindung betrifft somit eine Einrichtung zum reaktiven Sputtern, bei der an einer Kathode eine Entladespannung für ein Plasma anliegt und ein Arbeitsgas und ein Reaktivgas in eine Sputterkammer eingeleitet werden. Mit Hilfe eines Ventils wird der Gesamtgasfluss in der Sputterkammer gesteuert, während das Verhältnis der Partialdrücke der beiden Gase konstant gehalten wird.

Ein mit der Erfindung erzielter Vorteil besteht darin, dass die Entladespannung auch dann konstant gehalten werden kann, wenn bei einem Inline-Betrieb durch die aufeinander folgenden Substrate eine Veränderung der Spannungsverhältnisse bewirkt wird.

Ein Ausführungsbeispiel der Erfindung ist in den Zeichnungen dargestellt und wird im Folgenden näher beschrieben. Es zeigen:
- Fig. 1: eine Sputteranlage gemäß der Erfindung;
- Fig. 2: einen ersten Zusammenhang zwischen Kathodenspannung und Reaktivgasfluss;
- Fig. 3: einen zweiten Zusammenhang zwischen Kathodenspannung und Reaktivgasfluss;
- Fig. 4: einen Zusammenhang zwischen dem Ort eines an einer Sputterkathode vorbeibewegten Substrats und der Kathodenspannung

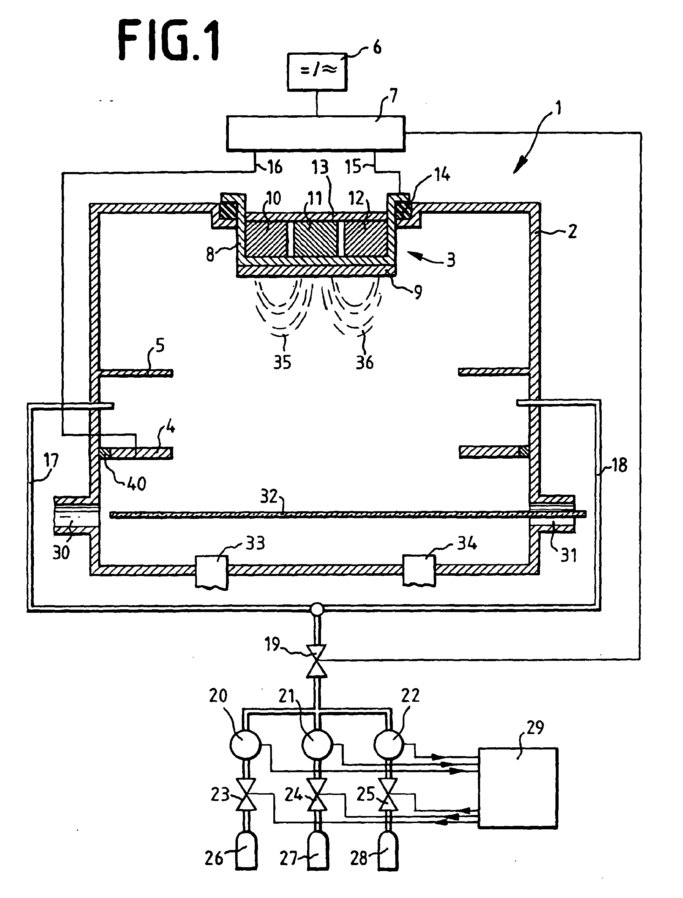

In der Fig. 1 ist das Prinzip einer Sputteranlage 1 dargestellt, die eine Sputterkammer 2, eine Kathode 3, eine Anode 4, eine Abschirmung 5, eine Spannungsquelle 6 und eine Regelschaltung 7 aufweist. Die Kathode 3 besteht aus einem wannenförmigen Kathodenteil 8, an dem ein zu zerstäubendes Target 9 angeflanscht ist. In dem wannenförmigen Kathodenteil 8 befinden sich drei Dauermagnete 10, 11, 12, die über ein Joch 13 miteinander verbunden sind.

Das Kathodenteil 8 ruht über eine Dichtung 14 auf einem Rand einer Öffnung in der Sputterkammer 2. Die Spannung der Spannungsquelle 6 gelangt über die Regelschaltung 7 mit ihrem einen Pol 15 auf den Kathodenteil 8 und mit ihrem anderen Pol 16 auf die Anode 4. Die Regelschaltung 7 hält die an die Anoden-Kathoden-Strecke abgegebene Spannung konstant, auch wenn die Spannung der Spannungsquelle 6 schwanken sollte. Das Schwanken der Entladespannung wird im Wesentlichen durch das vorbeifahrende Substrat bewirkt. Das Konstanthalten der Spannung wird dadurch erreicht, dass der Gesamtgasfluss, der über Gasleitungen 17, 18 in die Sputterkammer 2 gelangt, mittels eines regelbaren Ventils 19 geregelt wird. Dabei bleiben die Partialdrücke verschiedener Gase stets in gleichem Verhältnis. Dies wird durch eine Anordnung erreicht, welche z. B. drei Drucksensoren 20, 21, 22 und drei steuerbare Ventile 23, 24, 25 aufweist, mit denen der jeweilige Druck eines Gases aus einer Gasflasche 26, 27, 28 geregelt werden kann. Mit einer Regelschaltung 29 werden die Partialdrücke der Gase stets in konstantem Verhältnis gehalten. Diese Regelschaltung 29 kann auch in die Regelschaltung 7 integriert sein.

Unterhalb der Anode 4 sind in der Sputterkammer 2 zwei Öffnungen 30, 31 vorgesehen, durch welche eine zu beschichtende Platte 32 beispielsweise von links nach rechts geschoben werden kann. Unterhalb der Platte 32 befinden sich zwei Absaugstutzen 33, 34, die mit nicht dargestellten Pumpen verbunden sind, mit denen ein Quasi-Vakuum in der Sputterkammer 2 erzeugt werden kann. Mit 35, 36 sind Plasmawolken angedeutet, die sich bogenförmig vor dem Target 9 ausbreiten.

In der Gasflasche 26 kann sich beispielsweise Inertgas befinden, während sich in den Gasflaschen 27 und 28 verschiedene Reaktivgase befinden.

Bei dem Ventil 19 kann es sich um ein Butterfly-Ventil handeln. Ein solches Butterfly-Ventil entspricht vom Aufbau her der Drosselklappe eines Vergasers. Eine in ihrer Querschnittsfläche dem umgebenden Rohr angepasste Scheibe ist um ihre Symmetrieachse drehbar gelagert. Je nach Anstellwinkel der Scheibe zum Rohrquerschnitt wird mehr oder weniger Fläche des Rohrquerschnitts freigegeben. In der 90°-Stellung erhält man die größte Saugöffnung, in der 0°-Stellung ist die Saugöffnung verschlossen.

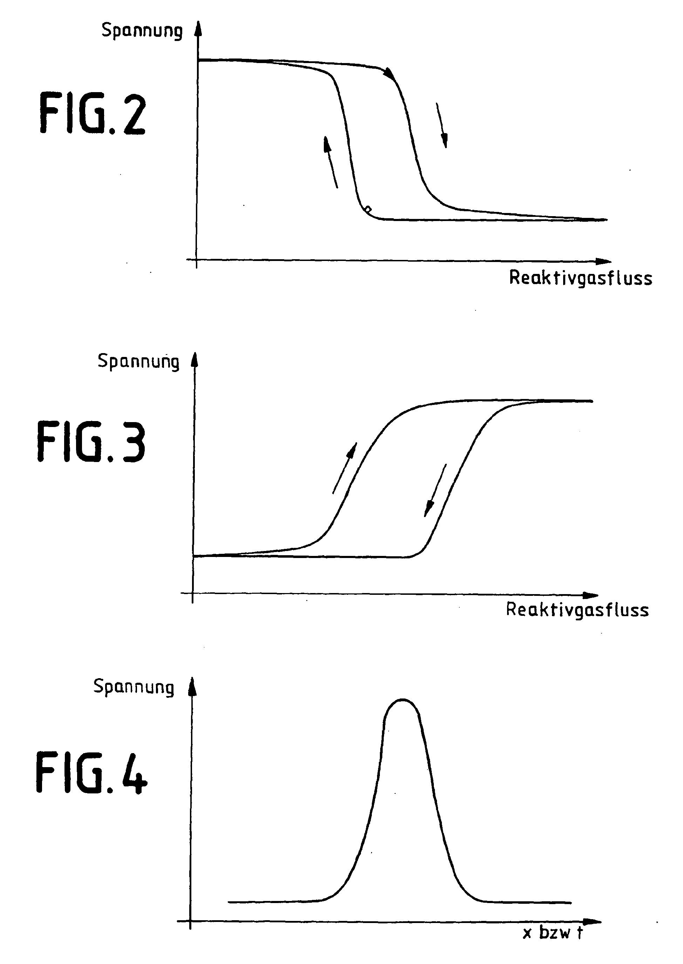

In der Fig. 2 ist der Zusammenhang zwischen Kathodenspannung und Reaktivgasfluss dargestellt. Man erkennt hierbei, dass die Kurve, welche diesen Zusammenhang wiedergibt, eine Hysterese aufweist. Man erkennt hierbei, dass mit steigendem Reaktivgasanteil die Entladespannung sinkt. Bei gleicher Leistung fließt somit ein höherer Strom bei niedrigerer Spannung.

Ab einem gewissen Punkt, der in der Kurve der Fig. 2 mit einem Dreieck gekennzeichnet ist, ist die sputternde Oberfläche des Targets so weit mit Reaktivprodukten belegt, dass wegen der niedrigen Sputterrate des Reaktivprodukts zuviel Reaktivgas für das mit reduziertem Oberflächenanteil sputternde reine Metall vorhanden ist, sodass die Targetoberfläche vollständig mit dem Reaktivprodukt belegt wird. Oberhalb dieses Punkts ist ein metastabiler Arbeitspunkt möglich, der mit dem Dreieck gekennzeichnet ist. Nähere Einzelheiten zu dem Hysterese-Effekt sind beispielsweise den Fig. 1 und 2 der US 6 511 584 zu entnehmen.

Die in der Fig. 2 dargestellte Hysterese hängt von der jeweiligen Kombination von Targetmaterial und Reaktivgas ab. So gibt es auch Hysterese-Kurven, die spiegelbildlich zu den Hysterese-Kurven nach Fig. 2 verlaufen. Eine solche Hysterese-Kurve ist in Fig. 3 dargestellt. Es ist dabei möglich, bei konstantem Inertgasfluss den Reaktivgasfluss zu verändern oder bei konstantem Reaktivgasfluss den Inertgasfluss anzupassen. Vereinfacht kann man sich vorstellen, dass das Inertgas in erster Linie als Arbeitsgas das Targetmaterial abträgt, während das Reaktivgas hauptsächlich für die chemische Reaktion benötigt wird.

Bei der vorliegenden Erfindung geht es darum, in einer Anlage mit wenigstens einer Sputterkathode, die von einer Anode und einer Abschirmung umgeben ist, die Entladespannung der Kathode bzw. der Kathoden konstant zu halten.

Auf das zu beschichtende Substrat 32 folgt dicht ein zweites (in der Fig. 1 nicht dargestelltes) Substrat, sodass zwischen beiden Substraten eine Lücke entsteht. Das Saugvermögen der Pumpen, die an die Stutzen 33, 34 angeschlossen sind, wird dadurch beeinträchtigt, d. h. das Saugvermögen schwankt. Der Querschnitt der Öffnungen der Stutzen 33, 34, durch die das Gas aus der Sputterkammer 2 abgepumpt wird, wird bei sich nach rechts bewegendem Substrat 32 zunehmend verdeckt, bis nur noch über den engen Spalt zwischen der Anode 4 und zwischen zwei aufeinander folgenden Substraten abgepumpt werden kann. Durch die Bewegung des Substrats 32 fällt das Saugvermögen vom Maximalwert bis auf einen Minimalwert. Bleibt die Gaszuführung konstant, steigt der Druck im Raum vor der Kathode 3 an. Der steigende Druck führt aber je nach Reaktivprozess zum Sinken oder zum Steigen der Entladespannung. Es ergibt sich dann eine vom Ort des Substrats abhängige Spannungskurve, wie sie in Fig. 4 gezeigt ist. Wenn das Substrat, das den Absaugstutzen abgedeckt und damit eine Veränderung des Saugleitwerts bewirkt hatte, den Saugquerschnitt wieder freigibt, nimmt die Entladespannung wieder den ursprünglichen Wert an. Anstelle der Ortskoordinaten x kann in der

Fig. 4 auch die Zeitkoordinate angegeben werden, weil der Ort von der Zeit über den Zusammenhang υ = x/t abhängt.

Dieser Spannungsänderung durch Abdecken des Saugquerschnitts wird erfindungsgemäß durch Regeln des Gasflusses entgegengewirkt.

Die Spannung an der Kathode und der Gasdruck sind wichtige Parameter zum Einstellen von Schichteigenschaften, wie z. B. von mechanischen Spannungen in den abgeschiedenen Schichten, die beispielsweise bewirken können, dass sich ein flexibles Substrat aufrollt oder die Schicht vom Substrat abreißt und sich aufrollt. Über diese Parameter kann das Schichtwachstum der abgeschiedenen Schichten beeinflusst werden, wie z. B. die Oberflächenrauigkeit, der elektrische Schichtwiderstand, ein mehr stängelförmiger oder dem Bulkmaterial ähnlicher Schichtaufbau, Porosität, Kristallinitätsgrad und dergleichen mehr.

Bei der hier verwendeten Spannungsregelung handelt es sich nicht um die in der Sputtertechnik übliche Spannungsregelung. Diese übliche Spannungsregelung ist eine Regelungsvariante für eine Sputterstromversorgung, deren Ausgangsspannung konstant gehalten wird, und zwar im Gegensatz zu einer Strom- oder Leistungsregelung, bei der der Strom bzw. die Leistung konstant gehalten werden.

Der Zusammenhang zwischen dem Konstanthalten der Spannung und dem Regeln des Drucks bei konstantem Partialdruckverhältnis ist komplex. In erster Näherung ist eigentlich die Sputterleistung proportional zur Sputterrate. Die Sputterrate besagt, wie viel Targetmaterial abgetragen wird, das dann mit dem Reaktivgas reagiert. Das Verhältnis von abgetragenem Material zum Reaktivgas muss konstant gehalten werden, damit dasselbe Reaktivprodukt entsteht, d. h. es müsste eigentlich mit dem Gasdruck die Sputterleistung konstant gehalten werden.

Ebenfalls in Näherung gilt, dass neben der elektrischen Leistung der Edelgasanteil der Prozessgasmischung als Arbeitsgas für die Sputterrate verantwortlich ist und der Reaktivgasanteil die chemische Reaktion bestimmt. Deshalb muss das Partialdruckverhältnis konstant gehalten werden.

Andererseits ist es bekannt, dass die Sputterspannung einen Einfluss auf das Schichtwachstum und somit auf die Schichteigenschaften hat, sodass es sinnvoll ist, die Spannung konstant zu halten. Wahrscheinlich überlagern sich mehrere Effekte derart, dass sie sich gegenseitig ausgleichen und es keinen messbaren Unterschied macht, ob die Spannung oder die Leistung konstant gehalten wird. Wenn sich zum Beispiel bei der vorgeschlagenen Regelung der Strom der Sputterentladung im erforderlichen Regelungsbereich nur wenig ändert, also in erster Näherung konstant bleibt, und andererseits die Spannung konstant gehalten wird, so bleibt auch die Sputterleistung und damit auch die Sputterrate konstant.

Wie stark sich bei konstanter Spannung der Strom der Entladung in Abhängigkeit vom Druck ändert, wird u. a. auch von der Strom-Spannungs-Kennlinie sowie der Spannungs-Druck-Kennlinie bestimmt. Beides sind konstruktionsabhängige Geräteeigenschaften der verwendeten Magnetrons.

## Patentansprüche

1. Einrichtung zum Regeln der Entladespannung beim reaktiven Sputtern in einer Inline-Anlage, bei der mehrere flächige Substrate (32) hintereinander durch eine Sputterkammer (2) bewegt werden, mit
1.1 wenigstens einer Kathode (3), an der eine Entladespannung für ein Plasma anliegt,
1.2 mehreren Gasbehältern (26 - 28), von denen jeder mit einem steuerbaren Ventil (23 - 25) versehen ist, wobei die von den Ventilen (23 - 25) gesteuerten Gase einer gemeinsamen Gasleitung zugeführt sind,
1.3 einem steuerbaren Ventil (19), mit dem der Gesamtgasfluss in der gemeinsamen Gasleitung steuerbar ist, um die Entladespannung zu regeln,
1.4 Drucksensoren (20 - 22), welche den Druck der Gase messen, die von den Ventilen (23 - 25) durchgelassen werden,
1.5 einer mit den Drucksensoren (20 - 22) verbundenen Regelung (29), mit welcher das Verhältnis der Partialdrücke der aus den Gasbehältern (26 - 28) ausströmenden Gase konstant gehalten wird.

2. Einrichtung nach Anspruch 1, **dadurch gekennzeichnet, dass** unterhalb des zu bearbeitenden Substrats (32) Absaugstutzen (33, 34) für das in der Sputterkammer (2) befindliche Gas vorgesehen sind.

3. Einrichtung nach Anspruch 1, **dadurch gekennzeichnet, dass** zwischen Substrat (32) und Kathode (3) eine Blende (4) vorgesehen ist.

4. Einrichtung nach Anspruch 1, **dadurch gekennzeichnet, dass** das Arbeitsgas Argon ist.

5. Einrichtung nach Anspruch 1, **dadurch gekennzeichnet, dass** das steuerbare Ventil (19), mit dem der Gesamtgasfluss gesteuert wird, ein Butterfly-Ventil ist.

## Claims

1. Device for controlling a discharge voltage in a sputter process in an inline arrangement, in which a plurality of areal substrates (32) are being moved through a sputter chamber (2), with
1.1 at least one cathode (3), to which a discharge voltage for a plasma is applied, and with
1.2 a plurality of gas containers (26-28), a controllable valve (23-25) being arranged to each of said gas containers (26-28), wherein the gases, being controlled by the valves (23-25), are supplied to a joint gas line,
1.3 a controllable valve (19), with which the total gas flow into the sputter chamber (2) can be controlled for regulating the discharge voltage,
1.4 pressure sensors (20-22) for measuring the pressure of the gases, which have passed the valves (23-25),
1.5 a regulation (29) arranged to the pressure sensors (20-22), with which the ratio of the partial pressures of the gases leaving the gas containers (26-28) is kept constant.

2. Device as claimed in claim 1, **characterized in that** beneath the substrate (32) to be worked evacuation ports (33, 34) for the gas in the sputter chamber (2) are provided.

3. Device as claimed in claim 1, **characterized in that** between substrate (32) and cathode (3) a shield (5) is provided.

4. Device as claimed in claim 1, **characterized in that** the working gas is argon.

5. Device as claimed in claim 1, **characterized in that** controllable valve (19) for controlling the total gas flow is a butterfly valve.

## Revendications

1. Dispositif pour le réglage de la tension de décharge lors de la pulvérisation réactive dans une installation en ligne, sur lequel plusieurs substrats (32) en deux dimensions sont déplacés les uns derrière les autres à travers une chambre de pulvérisation (2), comprenant
1.1 au moins une cathode (3), sur laquelle on applique une tension de décharge pour un plasma,
1.2 plusieurs réservoirs de gaz (26 - 28), dont chacun est doté d'une vanne (23 - 25) contrôlable, les gaz commandés par les vannes (23 - 25) étant amenés à une conduite de gaz commune,
1.3 une vanne (19) contrôlable, qui permet de contrôler le flux de gaz global dans la conduite de gaz commune afin de régler la tension de décharge,
1.4 des capteurs de pression (20 - 22) qui mesurent la pression des gaz transmis par les vannes (23 - 25),
1.5 un réglage (29) relié aux capteurs de pression (20 - 22) qui permet de maintenir constant le rapport des pressions partielles des gaz sortant des réservoirs de gaz (26 - 28).

2. Dispositif selon la revendication 1, **caractérisé en ce que** des tubulures d'aspiration (33, 34) pour le gaz se trouvant dans la chambre de pulvérisation (2) sont prévues au-dessous du substrat (32) à traiter.

3. Dispositif selon la revendication 1, **caractérisé en ce qu'**un obturateur (4) est prévu entre le substrat (32) et la cathode (3).

4. Dispositif selon la revendication 1, **caractérisé en ce que** le gaz de travail est de l'argon.

5. Dispositif selon la revendication 1, **caractérisé en ce que** la vanne (19) contrôlable, avec laquelle le flux de gaz global est commandé, est une vanne papillon.
